# EUROPEAN PATENT APPLICATION

(11) **EP 4 404 256 A1**
(43) Date of publication of application: **24.07.2024**
(21) Application number: 23152086.7
(22) Date of filing: 17.01.2023
(51) Int. Cl.: H01L 23/498, H01L 23/50

(54) **ELECTRONIC DEVICE WITH PADS SHIFTED TOWARDS A FUNCTIONALITY**

(71) Applicant: AT & S Austria Technologie & Systemtechnik Aktiengesellschaft, 8700 Leoben-Hinterberg (AT)
(72) Inventor: DONATELLO, Daniele, 8700 Leoben (AT); LEITGEB, Markus, 8793 Trofaiach (AT)
(74) Representative: Dilg, Haeusler, Schindelmann Patentanwaltsgesellschaft mbH

(57) **Abstract**

There is described an electronic device (100), said electronic device (100) comprising:
i) a semiconductor element (110) comprising a plurality of connection pads (112) on at least one main surface (111);
ii) a redistribution layer structure (120) coupled to the main surface (111) of the semiconductor element (110), wherein the redistribution layer structure (120) comprises:
iia) a first main surface (121) electrically associated to the main surface (111) of the semiconductor element (110),
iib) a second main surface (122) opposed to the first main surface (121),

iii) a plurality of first pads (123) exposed on the first main surface (121) and electrically connected to the plurality of connection pads (112), and
iv) a plurality of second pads (124) exposed at the second main surface (122);
v) a component carrier (130) coupled to the redistribution layer structure (120), wherein the component carrier (100) comprises:
va) at least one electrically insulating layer structure (132), and
vb) at least one electrically conductive layer structure (134), wherein the at least one electrically conductive layer structure (134) is electrically connected to the plurality of second pads (124); and

vi) at least one functional element (140) arranged in and/or on the component carrier (130);
wherein at least some of the second pads (124) are offset in the planar view with respect to the correspondent first pads (123) towards the location of the at least one functional element (140).

## Description

### Field of the Invention

The invention relates to an electronic device that comprises a semiconductor element, a redistribution layer structure, a component carrier, and a functional element. In particular, lower pads of the redistribution layer structure are shifted towards the functional element with respect to corresponding upper pads.

Accordingly, the invention may relate to the technical field of component carriers such as printed circuit boards or IC substrates in the context of electrical connection.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, electrically connecting several electric portions, such as a semiconductor component and a component carrier, within an assembly, such as an electronic device, may be considered a challenge. Issues may especially arise regarding the electrical connection between the semiconductor component (e.g. a chip), which generally comprises very small electric pads (connection terminals), and a component carrier (such as a circuit board), which generally comprises large electric pads (for example solder balls).

In order to "translate" between the small pads of the chip and the large pads of the circuit board, an interposer may be used, which comprises a redistribution layer (fan-out structure). In the context of the present document, the term "redistribution layer (RDL)" may in particular refer to an at least partially electrically conductive structure that is designed to translate a small electric contact at a first surface to a large electric contact at a second surface, in particular wherein first and second surface are arranged opposed to each other. For this purpose, the redistribution layer comprises a plurality of vertical structures (vias) and horizontal structures (traces) to enlarge the size of a small pad (e.g. of the chip) to the scale of a large pad (e.g. of the circuit board).

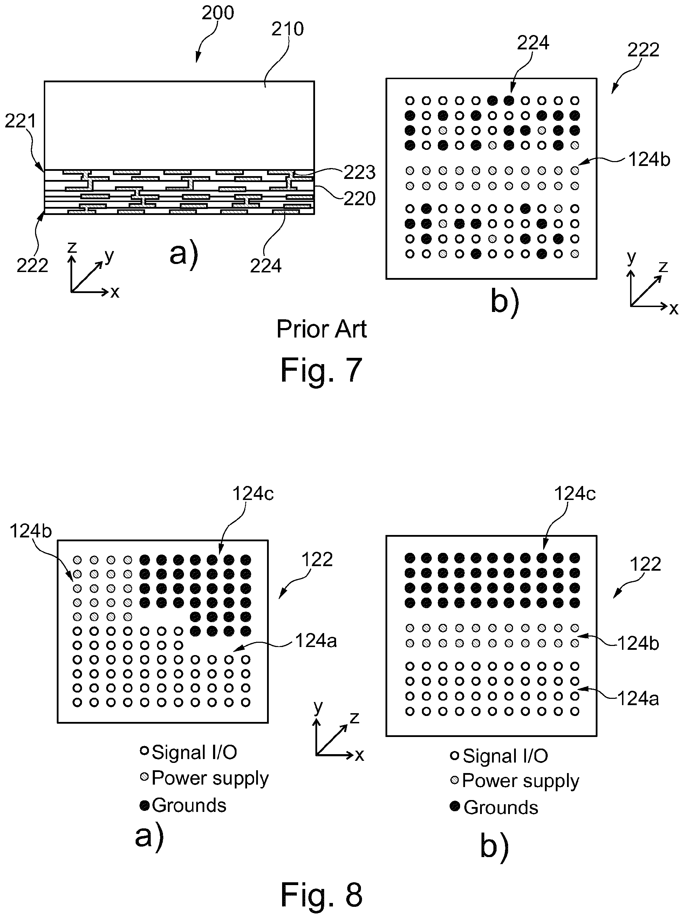

**Figure 7a** shows an example of a conventional arrangement of an IC chip 210 and a redistribution layer 220 connected below. While first pads 223 of the upper surface 221 of the redistribution layer 220 are electrically connected to pads of the IC chip 210, second pads 224 of the lower surface 222 of the redistribution layer 220 are exposed to be connected to a circuit board (not shown).

**Figure 7b** further shows a planar view (along the z-axis on the x-y plane) on the lower surface 222 of the redistribution layer 220. It can be seen that there is a high number of distributed second pads 224 (see also the remaining second pads 124b, described below for Figure 8b). Different functionalities of the second pads are illustrated with different schemes and it can be seen that the distribution of the different pads is completely mixed.

When the lower surface 222 of the redistribution layer 220 is placed onto a circuit board, in order to establish electric contacts, it may be especially challenging to realize efficient electric connections to specific functionalities of said circuit board.

### Summary of the Invention

There may be a need to provide electrical connections between electronic portions of an electronic device in an efficient, reliable, and design-flexible manner. An electronic device is provided.

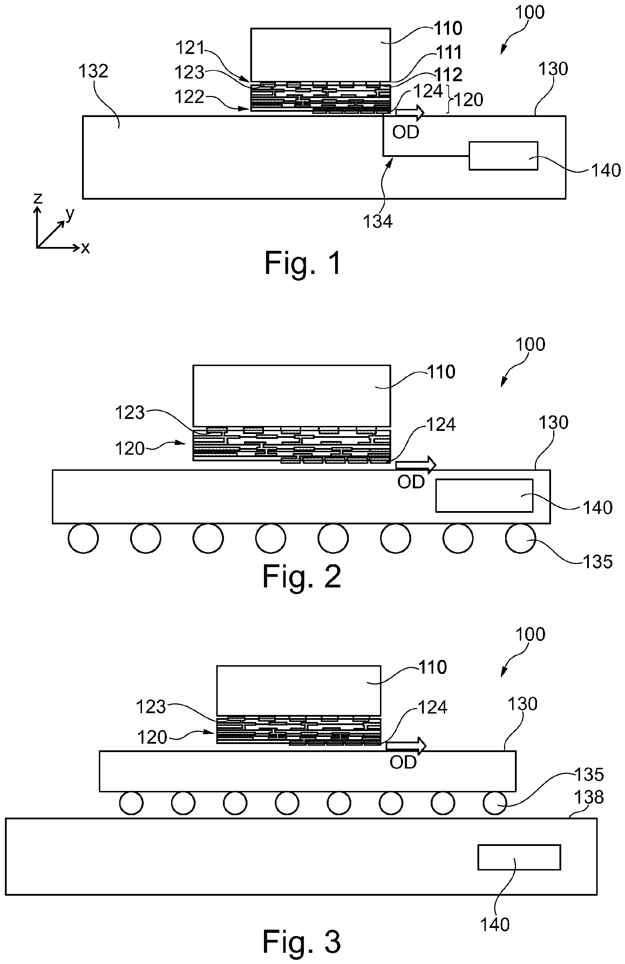

According to an aspect of the invention, there is described an electronic device, said electronic device comprising:
i) a semiconductor element (e.g. a semiconductor chip such as an IC chip) comprising a plurality of connection pads on at least one main surface;
ii) a redistribution layer structure coupled to the main surface of the semiconductor element, wherein the redistribution layer structure comprises:
   iia) a first main surface electrically associated (connected directly or indirectly) to the main surface of the semiconductor element, and
   iib) a second main surface opposed to the first main surface,
iii) a plurality of first pads provided (preferably) exposed on the first main surface and electrically connected to the plurality of connection pads (of the semiconductor element), and
iv) a plurality of second pads (preferably) exposed at the second main surface (wherein at least some of the second pads are associated with/correspond to respective first pads);
v) a component carrier (e.g. a printed circuit board or an IC substrate, a mounting base) coupled to the redistribution layer structure (in particular on the second surface of the redistribution layer structure), wherein the component carrier comprises:
   va) at least one electrically insulating layer structure (e.g. a resin), and
   vb) at least one electrically conductive layer structure (e.g. copper), wherein the at least one electrically conductive layer structure is electrically connected to the plurality of second pads (of the redistribution layer structure); and
vi) at least one functional element, in particular arranged in and/or on the component carrier (the component carrier can also be the mounting base and then a further component carrier would be arranged between redistribution layer structure and component carrier, see e.g. Figure 3).

Hereby, at least some of the second pads are offset in the planar view (when seen along the z-axis, in other words: the normal vector of the x-y plane) with respect to the correspondent first pads towards the location of the at least one functional element (in other words: second pads are shifted towards the functional element with respect to their corresponding first pads).

In the context of the present document, the term "semiconductor element" may in particular refer to an element, e.g. a component, that comprises at least one semiconductive material, i.e. a material with an electrical conductivity between a conductor (e.g. copper) and an insulator (e.g. resin). Such a semiconductive material is for example used in a (integrated) circuit. Hence, the semiconductor element may comprise one or more circuits, for example a die or a housed/packaged chip. The semiconductor element comprises electrical connection pads on at least one (main) surface. In an example, the connection pads are formed at the lower main surface of the semiconductor element. In another example, the connection pads are formed at the upper main surface of the semiconductor element.

In other words, the connection pads may be provided on the surface where the semiconductor element interacts with a further structure, preferably the redistribution layer structure; said interaction may comprise a mechanical coupling between the semiconductor element and the further structure, and/or an electrically coupling there between.

In the context of the present document, the term "redistribution layer structure" may refer to an RDL as described above. Further, the RDL structure may comprise a first (upper) main surface and an opposed (lower) main surface. The RDL structure may comprise electric pads at both main surfaces in order to translate a first pad size to a second pad size. In an example, the first main surface comprises a plurality of first pads (to be connected to the connection pads of the semiconductor element), while the second main surface comprises a plurality of second pads (to be connected to the component carrier, in particular to a functional element of the component carrier).

In an example, the redistribution layer structure further comprises at least one, preferably a plurality, of electrically insulating layer structures and at least one, preferably a plurality, of electrically conductive layer structure(s) connected one to each other to connect (at least some of) the plurality of first pads with (at least some of) the respective plurality of second pads. In an example, the electrically insulating layer structures comprise organic or inorganic material (in particular without fibrous fillers, with spherical fillers, or with no fillers, or without a fabric).

In the context of the present document, the term "functional element" may in particular refer to any physical element/device providing at least one technical function and being configured for being mounted on or embedded in a (further) component carrier. In an example, a functional element may be pre-fabricated and mounted/embedded as an inlay. Although a functional element may comprise one or more components, a functional inlay may be different from a (electronic) component only. In an example, one or more electric connections between the semiconductor element and the functional element may be desired, in particular regarding signal transmission, power supply, and connection to ground. Further functionalities may include at least one of: a power functionality (e.g. by passive components such as filter, capacitors, inductors) and/or active components (for example a DC-DC converter, a buck converter, a power management integrated circuit), security functionality (e.g. memory, crypto engine, clock), thermal functionality, electro-optical functionality (e.g. conversion, transmission), optical functionality (e.g. mirror, waveguide), shielding functionality (e.g. electromagnetic compatibility).

In the context of the present document, the term "main surface" may particularly denote one of two largest opposing surfaces of a device. The main surfaces may be connected by circumferential side walls. The thickness of a device, such as a stack, may be defined by the distance between the two opposing main surfaces.

In the context of the present document, the term "second pads are offset (shifted) in the planar view with respect to the correspondent first pads" may in particular describe the circumstance that second pads (at the second main surface of the RDL structure) are shifted with respect to the (respectively associated) first pads (at the first main surface of the RDL structure). This shift may hereby be oriented regarding the location of the functional element in or on the component carrier. In other words, the second pads are not formed at positions that correspond to the positions of the corresponding first pads (e.g. along the z-direction), but are instead moved/organized to be in closer proximity to the functional element (i.e. second pads are shifted away from a virtual vertical line (along z) drawn through the corresponding first pads).

This offset may be obtained by the at least one, preferably a plurality, of electrically insulating layer structures and at least one, preferably a plurality, of electrically conductive layer structure(s) of the redistribution layer structure, connected one to each other to connect the first pads with the respective second pads.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate, an IC (integrated circuit) substrate, a mounting base.

In the context of the present document, the term "IC substrate" may particularly denote a small component carrier. An IC substrate may be a, in relation to a PCB, comparably small component carrier onto which one or more components may be mounted and that may act as a connection medium between one or more chip(s) and a further PCB. More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. In an example, an IC substrate may be seen as an interposer, for example between electronic components and a printed circuit board.

In the present context, an IC substrate should not be understood as any substrate suitable to bear an IC. Instead, the term "IC substrate" may be a technically established term for a specific, high density PCB that comprises common PCB materials.

According to an exemplary embodiment, the invention may be based on the idea that electrical connections between electric portions of an electronic device (with a semiconductor element connected via a redistribution layer structure to a component carrier) can be provided in an efficient, reliable, and design-flexible manner, when second pads (at the component carrier side of the RDL structure) are offset towards a functional element (e.g. of the component carrier) in comparison to corresponding opposed first pads (connected to the semiconductor element).

Thereby, the distribution of electrical contacts may be optimized depending on the architecture of the component carrier and the functional element. The described electronic device may enhance the interaction between the semiconductor element and the (further) component carrier (functional element). In this manner, also the electrically conductive structure layout of the component carrier may be optimized, also regarding embedded components. The described concept may further be especially useful in electronic devices with multiple functionalities, for example a component carrier with ten or more embedded functional elements at different locations.

### Exemplary Embodiments

According to an embodiment, said at least some of the second pads are offset with respect to the first pads of a distance of at least the width of the first pads and/or the second pads along the offset direction. This may provide the advantage that the offset is large enough to enable an especially efficient and geographically optimized electric connection. The width of the pads can be seen as the width in the planar direction (x, y). In case that circular pads are used, the diameter may be seen as the width of the pad.

According to a further embodiment, at least some of the second pads are offset with respect to the first pads, and are grouped in a sub-portion of the second main surface. This may provide the advantage that sub-groups of second pads may be efficiently organized with respect to their function and/or the corresponding functional element. For example, a first group of second pads may be associated with a first functional element, while a second group of second pads may be associated with a second functional element. In this case, the first group may be offset towards the first functional element, while the second group may be offset towards the second functional element. Grouping may hence allow for an especially efficient architecture.

According to a further embodiment, only the at least some of the second pads are offset in the planar view with respect to the correspondent first pads towards the location of the functional element. In particular, the remaining pads are located and/or offset and/or grouped in the remaining portion of the second main surface. This may provide the advantage that the design-flexibility is highly increased. While some (sub-groups of) second pads may be offset, e.g. in first sub-portions of the second mains surface, further (sub-groups of) second pads may remain in their location, e.g. in a second sub-portion of the second main surface.

According to a further embodiment, some of the plurality of connection pads are configured to transmit signal input/output to/from the semiconductor element. According to a further embodiment, some of the plurality of connection pads are configured to transmit power to the semiconductor element. According to a further embodiment, some of the plurality of connection pads are configured to connect the semiconductor element to ground. This may provide the advantage that technically/economically important and/or established functionalities can be directly addressed and implemented toward the respective functional elements.

According to a further embodiment, some of the plurality of second pads, which are offset in the planar view with respect to the correspondent first pads, are those
i) configured to transmit signal input/output to/from the semiconductor element, and/or
ii) configured to transmit power supply to the semiconductor element, and/or iii) configured to connect the semiconductor element to ground.
As described above, in this manner, important functionalities can be directly improved based on the offset second pads.

According to a further embodiment, at least some of the second pads are electrically connected to the respective first pads, and the respective first pads are connected to the respective connection pads, so that each of the at least some of the second pads are configured to
i) transmit signal input/output to/from the semiconductor element, and/or
ii) transmit power supply to the semiconductor element, and/or
iii) connect the semiconductor element to ground.
As described above, in this manner, important functionalities can be directly improved based on the offset second pads.

According to a further embodiment, at least one functional element comprises a (electronic) component managing/transmitting/requiring a specific signal and/or power supply and/or ground connection. According to a further embodiment, the plurality of the second pads are offset in the planar view with respect to the correspondent first pads, so that the required second pads configured to
i) transmit signal input/output to/from the semiconductor element, and/or ii)
ii) transmit power supply to the semiconductor element, and/or
iii) be connected to the ground,
are offset towards the location of the functional element.
This may provide the advantage that the (electronic) component can be supported and connected in an efficient and reliable manner, optimizing the connections layout due to the offset of the second pads in dependence of their specific functionalities and the respective functional element.

According to a further embodiment, the at least one functional element comprises at least one functional volume section. This may provide the advantage that the design-flexibility is highly increased. Additionally, an efficient miniaturization may be enabled by providing two or more functional volume sections in one functional element. The term "functional volume section" may in this context refer to a subsection of a functional element. For example, a functional element may comprise a plurality of different (separate) functional volume sections.

The functional volume sections in combination with the offset of the second pads enhances the grouping of specific functionalities in specific position of the electronic device (i.e. in terms of planar positions and/or thickness positions), allowing the shifting pads toward a well-recognized optimal position, resulting in an optimized connections layout.

According to a further embodiment, at least one of the functional volume section comprises at least one of the following:
i) a power distribution function, in particular a redistribution structure,
ii) a power delivery function, in particular provided by a plurality of embedded capacitor components,
iii) at least one security-related component,
iv) at least one heat management structure,
v) at least one electro-optical structure.
This may provide the advantage that technically/economically important functionalities may be combined in a functional element, which is most efficiently electrically connected to the offset second pads. Especially in case of a component carrier that comprises a plurality of functional element and/or functional volume sections, the described offset second pads may enable the necessary highly efficient electric connection.

According to a further embodiment, the at least one functional volume section is electrically connected (exclusively connected or the majority of the connections are connected) to the second pads configured to
i) transmit/receive signal input/output to/from the semiconductor element, and/or
ii) transmit power supply to the semiconductor element, and/or
iii) be connected to the ground,
and are offset towards the location of the functional volume section.
Like in case of the functional element described above, important functional volume sections may be efficiently connected with a high design-flexibility.

According to a further embodiment, the at least one functional volume section (and/or the functional element) is provided in a layer structure (e.g. a core layer structure) of the component carrier, in particular in a cavity provided in a layer structure of the component carrier. This may provide the advantage that the functionality can be embedded in a layer of a stack, thereby being protected and requiring less space.

According to a further embodiment, the component carrier comprises an integrated circuit substrate, in particular wherein the redistribution layer structure is connected (as an interposer) to the integrated circuit substrate (see e.g. Figure 2).

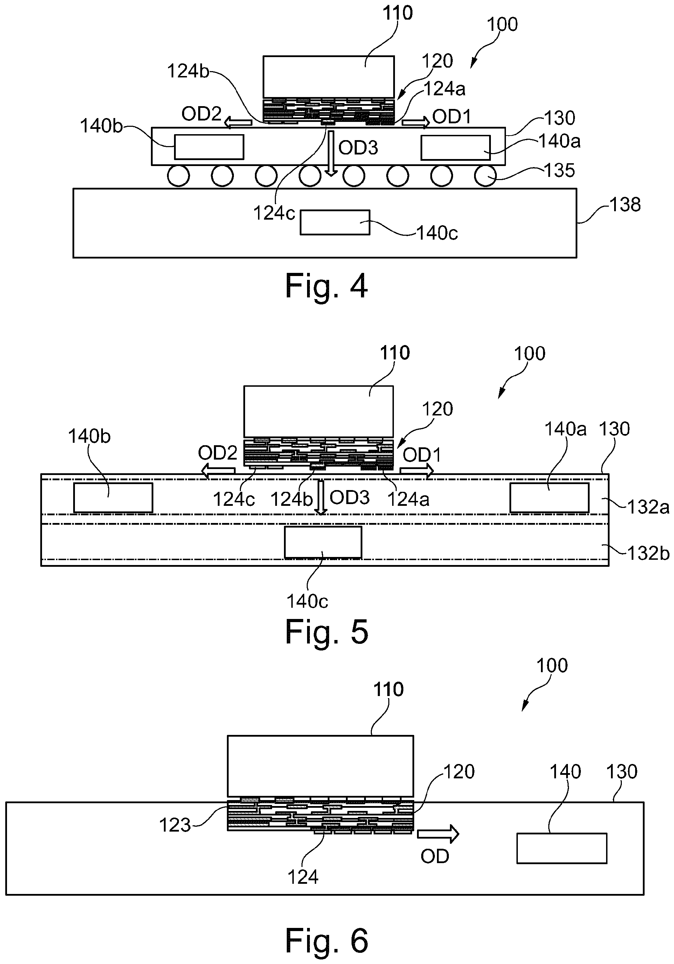

According to a further embodiment, the redistribution layer structure is integrated (at least partially embedded) in the component carrier (see e.g. Figure 6) or the mounting base (see below). In particular, the first main surface/the first pads are faced/exposed to one (upper) main surface of the component carrier or mounting base. Thereby, the electronic device may require less space and the RDL structure is protected in the component carrier material.

According to a further embodiment, the component carrier comprises a mounting base (a further component carrier), in particular a printed circuit board and/or an interposer. The description of embodiments of the component carrier may also be applicable to the mounting base, when being configured as a component carrier. Hereby, a further component carrier may be arranged between RDL structure and component carrier (mounting base), see e.g. Figure 3. In another embodiment, the mounting base may be configured as a substrate to support the component carrier, e.g. a frame structure.

According to a further embodiment, the component carrier (in particular configured as an IC substrate) is connected (mounted on or at least partially embedded in) to the mounting base.

Accordingly, the electronic device may comprise a plurality of electronic portions that may be electrically interconnected in a highly efficient and reliable manner.

According to a further embodiment, at least one of the functional element(s) and/or the functional volume section(s) is located in/on the mounting base or in/on the component carrier (IC) substrate, and the at least some of the second pads are offset in the planar view towards the location of the functional element and/or the functional volume section (see for example Figure 3). In this embodiment, the component carrier may serve as a further interposer between semiconductor element and the electronic portion (here the mounting base), wherein the functionality is located.

Independently of the location of the at least one of the functional element(s) and/or the functional volume section(s) in the electronic device, in particular the electronic package, and/or irrespective of its positioning in one of the component (mounting base, component carrier (IC) substrate) composing this package, the second pads are offset along a plan view, optimizing the connection along of the assembly direction of the package components.

According to a further embodiment, a plurality of functional elements (and/or a plurality of functional volume sections) are provided, in particular some of said functional elements and/or functional volume sections are provided/located at the same vertical level with respect to the thickness of the component carrier and/or mounting base (see for example Figure 5). This may provide the advantage that the functionalities can be addressed efficiently and reliably at a same area/level/layer, using the same
features/dimensions/materials necessary for these functionalities. Further, the functionalities may be manufactured in a common process, e.g. by embedding in a component carrier cavity. While a first group of second pads may be offset towards a first functionality, a second group of second pads may be offset (in another direction) towards the second functionality.

According to a further embodiment, at least one of the functional element(s) and/or functional volume section(s) is provided at a first vertical level (on/in a layer) of the component carrier (or mounting base), and at least one further functional element and/or functional volume section is provided at a second vertical level of the component carrier (or mounting base).

According to a further embodiment, at least some of the second pads are offset towards the at least one of the functional element and/or functional volume, and other second pads are offset/placed towards/aligned with the further functional element and/or functional volume section (see e.g. Figure 5).

In an example, the first vertical level and the second vertical level are defined by layer structures of the component carrier (or the mounting base). In another example, the first vertical level is located in the component carrier, while the second vertical level is located in the mounting base.

According to a further embodiment, the at least some of the second pads are offset in the planar view with respect to the correspondent first pads in different directions towards the location of the respective functional elements and/or functional volume sections (see e.g. Figures 4 and 5). In case that several functional elements are located in different positions, it may be highly advantageous to also shift the position of the corresponding second pads, respectively. In particular, the second pads that are associated with one functionality may be grouped and the group of second pads may then be offset towards said functional element.

According to a further embodiment, the semiconductor element and the redistribution structure are integrated in a component assembly. This may provide the advantage that a highly compact electronic device may be provided. Such a component assembly (e.g. a package) may be handled in a flexible manner and mounted on (or embedded in) the component carrier.

According to a further embodiment, the redistribution layer structure has a planar area extension equal or smaller than the planar extension of the semiconductor element. Material and effort may be saved, when the RDL structure comprises a size sufficient to fulfill its (interposing) function.

According to an exemplary embodiment, the invention may be focused on the change of distribution of the contacts from the chip (semiconductor element) level to the opposed redistribution layers side in relation of the PCB/substrate layout (i.e. via/components placements) and eventually to the combination of some contacts in the redistribution layers to simplify the chip interface with the PCB/substrate. The invention may be particularly useful where bundles of contacts (second pads) having common functions (such as signal contacts) are grouped (and/or moved) towards specific sub-areas in the PCB/substrate main surface due to their specific configurations.

In an embodiment, the component carrier is configured as one of the group consisting of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" (e.g. a FCBGA) may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metaloxide-semiconductor field-effect transistor (MOSFET), complementary metaloxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

The aspects defined above and further aspects of the invention are apparent from the examples of embodiment to be described hereinafter and are explained with reference to these examples of embodiment.

### Brief Description of the Drawings

The aspects defined above and further aspects of the invention are apparent from the examples of embodiment to be described hereinafter and are explained with reference to these examples of embodiment.
Figures 1 to 6 respectively show an electronic device according to exemplary embodiments of the invention.
Figures 7a and 7b show an example of a conventional device.
Figures 8a, 8b, and 9 show a planar view on the offset second pads at the second main surface according to exemplary embodiments of the invention.

### Detailed Description of the Drawings

The illustrations in the drawings are schematic. In different drawings, similar or identical elements are provided with the same reference signs.

**Figure 1** shows an electronic device 100 according to an exemplary embodiment of the invention. The electronic device 100 comprises in principle three portions: a semiconductor element 110, a redistribution layer (RDL) structure 120, and a component carrier 130, wherein the RDL structure is used as an interposer between semiconductor element 110 and component carrier 130.

The semiconductor element 110 is in this example a packaged IC (chip) that comprises at the lower/bottom main surface 111 a plurality of exposed electric connection pads 112.

The redistribution layer structure 120 comprises a plurality of electrically conductive traces and vias embedded in dielectric material. A first (upper) main surface 121 of the RDL structure 120 is electrically associated, i.e. in contact, to the (lower) main surface 111 of the semiconductor element 110. In turn, a second (lower) main surface 122 of the RDL structure 120 is arranged opposed to the first main surface 121 and is associated with the component carrier 130. Further, the redistribution layer structure 120 comprises a plurality of first pads 123 provided on the (upper) first main surface 121 and electrically connected to the plurality of (small) connection pads 112 of the semiconductor element 110. The RDL structure 120 also comprises a plurality of second pads 124 exposed at the (lower) second main surface 122 and electrically connected to an (large) electrical contact (not shown) of the component carrier 130.

The component carrier 130 is configured in this example as a printed circuit board (PCB) or IC substrate with a multilayer stack (not shown in detail). The component carrier 100 comprises in said stack a plurality of electrically insulating layer structures 132 and electrically conductive layer structures 134. Some of the electrically conductive layer structures 134 are electrically connected (via the above mentioned electric contact) to the plurality of second pads 124 of the RDL structure 120 (only shown schematically).

The electronic device 100 further comprises a functional element 140 which is in this example embedded in the component carrier 130 (layer stack). It can be seen that at least some of the second pads 124 are offset along an offset direction OD in the side view (in the planar view it is shown in Figures 8a and 8b) with respect to the corresponding first pads 123. The offset (shift) is hereby oriented towards the location of the functional element 140. The offset of the second pads 124 with respect to the first pads 123 is at least the width of the first pads 123 and/or the second pads 124 along the offset direction OD.

**Figure 2** shows an electronic device 100 according to a further exemplary embodiment of the invention. This example is very similar to the one described for Figure 1. The difference being that the component carrier 130 is thinner (in the z-direction) and comprises at the lower main surface a plurality of electric contacts 135, here realized as solder balls. In this example, the component carrier 100 is configured as an IC substrate.

**Figure 3** shows an electronic device 100 according to a further exemplary embodiment of the invention. In this example, the electronic device 100 further comprises a mounting base 138, which is here a further component carrier. For example, the component carrier 130 can be configured as an IC substrate, while the further component carrier 138 can be configured as a printed circuit board (or a frame structure). The component carrier 130 is mounted via the electric contacts 135 (solder balls) onto the mounting base 138. In the example shown, the functional element 140 is embedded in the mounting base 138 (being part of the electronic device 100) instead of the component carrier 130.

The second pads 124 are offset in the offset direction OD (in the planar view) towards the location of the functional element 140 in the mounting base 138.

**Figure 4** shows an electronic device 100 according to a further exemplary embodiment of the invention. In this example, there is not only one functional element 140 in the electronic device 100, but three functional elements (which can also be seen as functional element volume sections) 140a-c. A first functional element 140a is embedded at the right side periphery of the component carrier 130, while a second functional element 140b is embedded at the left side periphery of the component carrier 130. Additionally, a third functional element 140c is embedded at the center of the mounting base 138.

The second pads 124 are now grouped in sub-groups depending on the location of the corresponding functional element 140a-c. The sub-groups of second pads 124 are offset with respect to the corresponding first pads 123 regarding a sub-portion of the second main surface 122. In the example shown, a first group 124a of second pads 124 is offset in a first offset direction OD1 towards the first functional element 140a (i.e. to the right side). A second group 124b of second pads 124 is offset in second offset direction OD2 towards the second functional element 140b (i.e. to the left side). Further, a third group 124c of second pads 124 is offset in a third offset direction OD3 towards (or is alternatively simply aligned with) the third functional element 140c (i.e. to the center of the second main surface 122).

**Figure 5** shows an electronic device 100 according to a further exemplary embodiment of the invention. In this example, the component carrier 130 is configured as a multilayer stack printed circuit board with a plurality of electrically insulating layer structures 132a, 132b. While a first and a second functional element 140a, 140b are located (in a respective cavity) at the outer periphery of an upper electrically insulating layer structure 132a of the component carrier 130 (on the same vertical level), a third functional element 140c is located in (a cavity of) the center of a lower electrically insulating layer structure 132b of the component carrier 130.

As described for Figure 4 above, a first group 124a of second pads 124 is offset (OD1) towards the first functional element 140a, while a second group 124b of second pads 124 is offset (OD2) towards the second functional element 140b. A third group 124c of second pads 124 is offset to (or is alternatively simply aligned with) the center of the second main surface 122 towards the third functional element 140c.

**Figure 6** shows an electronic device 100 according to a further exemplary embodiment of the invention. This embodiment is very similar to the one described for Figure 1, with the difference being that the redistribution layer structure 120 is embedded in the component carrier 130 (instead of being mounted on the component carrier 130). The second pads 124 are shifted in the same manner towards the functional element 140.

**Figures 8a and 8b** respectively show a planar view (along the z-axis on the x-y plane) on the second main surface 122 of the redistribution layer structure 120 according to exemplary embodiments of the invention.

Figure 8a: there are shown three sub-groups 124a-c of second pads 124 which are respectively offset with respect to the corresponding first pads 123 (not shown).

The first group 124a of second pads 124 is dedicated to transmit signal input/output to/from the semiconductor element 110 with respect to the functional element 140.

The second group 124b of second pads 124 is dedicated to supply power with respect to the semiconductor element 110 and/or the functional element 140.

The third group 124c of second pads 124 is dedicated to connect the semiconductor element 110 to ground.

Figure 8b: in this example, some of the second pads 124 (here the second group 124b) are remaining pads, grouped in a remaining portion of the second main surface 122 without being offset (compare Figure 7b).

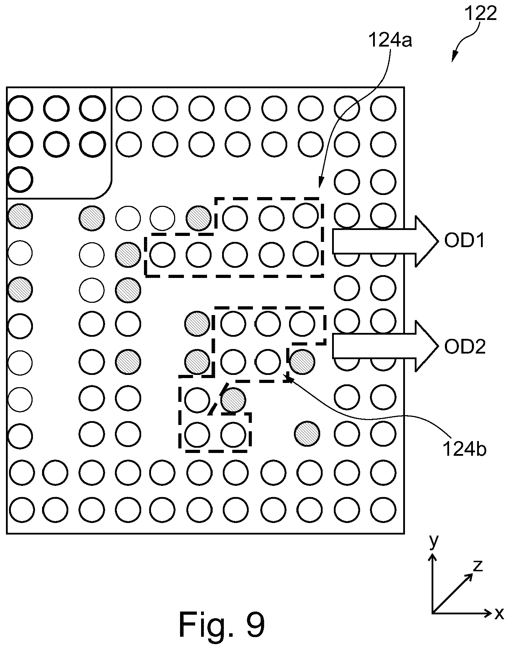

**Figure 9** shows a planar view (along the z-axis on the x-y plane) on the second main surface 122 of the redistribution layer structure 120 according to a further exemplary embodiment of the invention. In comparison to the embodiments of Figures 8a and 8b, the seconds pads 124a, 124b are shifted only slightly (a little bit) OD1, OD2 with respect to the corresponding first pads. For example, the seconds pads 124a, 124b are offset with respect to the first pads of a distance corresponding to the width (preferably the diameter) of the first pads 123 and/or the second pads 124 along the offset direction OD. The second pads 124a, 124b shifted toward the same direction OD1, OD2, even slightly, are in this example those related to the same functional element/section and/or the same kind of electric passage (signal or power or ground).

### Reference signs

- 100: Electronic device
- 110: Semiconductor element
- 111: Semiconductor element main surface
- 112: Connection pads
- 120: Redistribution layer structure
- 121: First main surface
- 122: Second main surface
- 123: Plurality of first pads
- 124: Plurality of second pads
- 130: Component carrier
- 132: Electrically insulating layer structure
- 134: Electrically conductive layer structure
- 135: Component carrier electric contact, solder balls
- 138: Mounting base, further component carrier
- 140: Functional element
- OD: Offset direction

- 200: Conventional electronic device
- 210: Conventional chip
- 220: Conventional interposer
- 221: Conventional upper main surface
- 222: Conventional lower main surface
- 223: Conventional first pads
- 224: Conventional second pads

## Claims

1. An electronic device (100), said electronic device (100) comprising:
a semiconductor element (110) comprising a plurality of connection pads (112) on at least one main surface (111);
a redistribution layer structure (120) coupled to the main surface (111) of the semiconductor element (110), wherein the redistribution layer structure (120) comprises:
a first main surface (121) electrically associated to the main surface (111) of the semiconductor element (110),
a second main surface (122) opposed to the first main surface (121),
a plurality of first pads (123) provided on the first main surface (121) and electrically connected to the plurality of connection pads (112), and
a plurality of second pads (124) exposed at the second main surface (122);
a component carrier (130, 138) coupled to the redistribution layer structure (120), wherein the component carrier (100) comprises:
at least one electrically insulating layer structure (132), and
at least one electrically conductive layer structure (134), wherein the at least one electrically conductive layer structure (134) is electrically connected to the plurality of second pads (124); and
at least one functional element (140), said functional element (140) being arranged in/on the component carrier (130, 138);
wherein at least some of the second pads (124) are offset in the planar view with respect to the correspondent first pads (123) towards the location of the at least one functional element (140).

2. The electronic device (100) according to claim 1,
wherein said at least some of the second pads (124) are offset with respect to the first pads (123) by a distance of at least the width of the first pads (123) and/or the second pads (124) along the offset direction (OD).

3. The electronic device (100) according to any of claims 1 to 2,
wherein at least some of the second pads (124) are offset with respect to the first pads (123) and are grouped in a sub-portion of the second main surface (122).

4. The electronic device (100) according to any of claims 1 to 3,
wherein only the at least some of the second pads (124) are offset in the planar view with respect to the correspondent first pads (123) towards the location of the functional element (140),
in particular wherein the remaining pads (123, 124) are located and/or offset and/or grouped in the remaining portion of the second main surface (122).

5. The electronic device (100) according to any of claims 1 to 4,
wherein some of the plurality of connection pads (112) are configured to transmit signal input/output to/from the semiconductor element (110); and/or wherein some of the plurality of connection pads (112) are configured to transmit power to the semiconductor element (110); and/or
wherein some of the plurality of connection pads (112) are configured to connect the semiconductor element (110) to ground.

6. The electronic device (100) according to claim 5,
wherein some of the plurality of second pads (124), which are offset in the planar view with respect to the correspondent first pads (123), are those configured to transmit signal input/output to/from the semiconductor element (110), and/or
configured to transmit power supply to the semiconductor element (110), and/or
configured to connect the semiconductor element (110) to ground.

7. The electronic device (100) according to claim 5 or 6,
wherein at least some of the second pads (124) are electrically connected to the respective first pads (123), and
wherein the respective first pads (123) are connected to the respective connection pads (112), so that each of the at least some of the second pads (124) are configured to
transmit signal input/output to/from the semiconductor element (110), and/or transmit power supply to the semiconductor element (110), and/or
connect the semiconductor element (110) to ground.

8. The electronic device (100) according to claim 7,
wherein the at least one functional element (140) comprises a component managing/transmitting/requiring a specific signal and/or power supply and/or ground connection,
wherein the plurality of the second pads (124) are offset in the planar view with respect to the correspondent first pads (123), so that the required second pads (124) are configured to
transmit signal input/output to/from the semiconductor element (110), and/or transmit power supply to the semiconductor element (110), and/or
be connected to the ground,
are offset toward the location of the functional element (140).

9. The electronic device (100) according to any of claims 1 to 8,
wherein the at least one functional element (140) comprises at least one functional volume section.

10. The electronic device (100) according to claim 9,
wherein at least one of the functional volume section comprises
a power distribution function, in particular a redistribution structure, and/or
a power delivery function, in particular provided by a plurality of embedded capacitor components, and/or
at least one security-related component, and/or
at least one heat management structure, and/or
at least one electro-optical structure.

11. The electronic device (100) according to claim 9 or 10,
wherein the at least one functional volume section is electrically connected to the second pads (124) configured to
transmit/receive signal input/output to/from the semiconductor element (110), and/or
to transmit power supply to the semiconductor element (110), and/or
be connected to the ground,
and is offset towards the location of the functional volume section.

12. The electronic device (100) according to any one of claims 1 to 11,
wherein at least one of the functional elements (140) and/or functional volume sections is provided at a first vertical level of the component carrier (130), and at least one further functional element (140) and/or functional volume sections is provided at a second vertical level of the component carrier (130, 138),
wherein at least some of the second pads (124) are offset towards the at least one of the functional elements (140) and/or functional volumes, and
wherein other second pads (124) are offset towards the further functional element and/or functional volume section.

13. The electronic device (100) according to claim 11 or 12,
wherein the at least some of the second pads (124) are offset in the planar view with respect to the correspondent first pads (123) in different directions towards the location of the respective functional elements (140) and/or functional volume sections.

14. The electronic device (100) according to any of claims 1 to 13,
wherein the semiconductor element (110) and the redistribution structure (120) are integrated in a component assembly.

15. The electronic device (100) according to any one of claims 1 to 13,
wherein the redistribution layer structure (120) has a planar area extension equal or smaller than the planar extension of the semiconductor element (110).
